# EUROPEAN PATENT APPLICATION

(11) **EP 4 424 974 A2**
(43) Date of publication of application: **04.09.2024**
(21) Application number: 24155938.4
(22) Date of filing: 06.02.2024
(51) Int. Cl.: F01C 21/08, F04C 18/08, F04C 18/12, F04C 25/02

(54) **VACUUM PUMP AND METHOD OF DETERMINING SHAPE OF ROOTS ROTOR**

(30) Priority: 08.02.2023 JP 2023017363
(71) Applicant: EBARA CORPORATION, Ota-ku, Tokyo 144-8510 (JP)
(72) Inventor: SUGIURA, Tetsuro, Tokyo, 1448510 (JP); NAGAYAMA, Masami, Tokyo, 1448510 (JP); KAMATKAR, Anagha, Tokyo, 1448510 (JP); HORIBE, Yuga, Tokyo, 1448510 (JP); OBUCHI, Masashi, Tokyo, 1448510 (JP)
(74) Representative: Carstens, Dirk Wilhelm

(57) **Abstract**

Vacuum pump comprising a first (8) and a second (9) Roots rotor wherein each the Roots rotors (8,9) has an involute side surface (31) having a shape of an involute curve , an arcuate convex surface (34) coupled to an outer end of the involute side surface (31), and an arcuate concave surface (36) coupled to an inner end of the involute side surface (31). A radius of curvature of the arcuate convex surface (31) is smaller than a radius of curvature of the arcuate concave surface (36).

Method of determining a shape of a Roots rotor by calculating inter-rotor clearances.

## Description

### BACKGROUND OF THE INVENTION

### Field of the Invention:

The present invention relates to a vacuum pump, and more particularly to a vacuum pump suitable for use in evacuating a process gas used in manufacturing of semiconductor devices, liquid crystal panels, LEDs, solar cells, or the like.

### Description of the Related Art:

In process of manufacturing semiconductor devices, liquid crystal panels, LEDs, solar cells, etc., a process gas is introduced into a process chamber to perform a certain type of process, such as etching process or CVD process. The process gas that has been introduced into the process chamber is exhausted by a vacuum pump. Generally, the vacuum pump used in these manufacturing processes that require high cleanliness is so-called dry vacuum pump that does not use oil in its gas flow passage. One typical example of such a dry vacuum pump is a positive-displacement vacuum pump having a pair of Roots rotors in a rotor chamber which are rotated in opposite directions to deliver the gas.

### Citation List

### Patent Literature

Patent document 1: Japanese laid-open patent publication No. 1-077782 A process gas may contain particles of by-products. Such particles flow into the vacuum pump along with the process gas. Moreover, depending on conditions in the vacuum pump (e.g., temperature, pressure), particles may be generated in the vacuum pump after the process gas flows into the vacuum pump. Most of the particles are discharged from the vacuum pump along with the process gas, but some of the particles remain in the rotor chamber and gradually accumulate in the rotor chamber. In particular, when convex and concave surfaces of two opposing Roots rotors are in surface contact (technically, the Roots rotors are in non-contact in reality), there is no place for the particles to escape. As a result, the particles are strongly sandwiched between the convex and concave surfaces of the Roots rotors, thus possibly hindering the rotation of the Roots rotors.

### SUMMARY OF THE INVENTION

Therefore, the present invention provides a vacuum pump capable of preventing particles from being caught between Roots rotors and capable of maintaining smooth rotation of the Roots rotors. The invention further provides a method of determining a shape of such Roots rotors.

In an embodiment, there is provided a vacuum pump comprising: a pump casing having at least one rotor chamber therein; and a first Roots rotor and a second Roots rotor arranged in parallel in the rotor chamber, wherein each of the first Roots rotor and the second Roots rotor has an involute side surface having a shape of an involute curve, an arcuate convex surface coupled to an outer end of the involute side surface, and an arcuate concave surface coupled to an inner end of the involute side surface, and a radius of curvature of the arcuate convex surface is smaller than a radius of curvature of the arcuate concave surface.

In an embodiment, each of the arcuate convex surface and the arcuate concave surface is longer than the involute side surface.

In an embodiment, a width of a space formed between the arcuate convex surface and the arcuate concave surface when facing each other increases with a distance from a position of a minimum clearance between the arcuate convex surface and the arcuate concave surface.

In an embodiment, the radius of curvature of the arcuate convex surface is 0.2 to 0.9 times the radius of curvature of the arcuate concave surface.

In an embodiment, there is provided a method of determining a shape of a Roots rotor, comprising: generating, by an arithmetic system, multiple candidates for the Roots rotor each having a shape that satisfies specifications of the Roots rotor while changing the specifications of the Roots rotor; calculating, by the arithmetic system, multiple clearances between a pair of Roots rotors corresponding to multiple rotation angles of the pair of Roots rotors having a shape of one of the multiple candidates; determining a maximum clearance among the multiple clearances; repeating calculating of the multiple clearances and determining of the maximum clearance for the multiple candidates to determine multiple maximum clearances corresponding to the multiple candidates; and determining a shape of the Roots rotor of a candidate corresponding to a smallest maximum clearance among the multiple maximum clearances.

In an embodiment, the method further comprises calculating additional clearances corresponding to additional rotation angles by performing interpolation for the multiple clearances corresponding to the multiple rotation angles, wherein the maximum clearance is determined from among the multiple clearances and the additional clearances.

In an embodiment, Roots rotors having the determined shape are the first Roots rotor and the second Roots rotor.

In an embodiment, the specifications of the Roots rotor include at least one of a distance between centers of a pair of Roots rotors, a pressure angle of the involute side surface of Roots rotor, a radius of Roots rotor, a clearance between Roots rotors, a radius of curvature of the arcuate convex surface of Roots rotor, and a radius of curvature of the arcuate concave surface of Roots rotor.

Since the radius of curvature of the arcuate convex surface of the first Roots rotor is smaller than the radius of curvature of the arcuate concave surface of the second Roots rotor, a minimum clearance is formed between one point on the arcuate convex surface of the first Roots rotor and one point on the arcuate concave surface of the second Roots rotor. A clearance between the Roots rotors gradually increases on both sides of the minimum clearance. Therefore, the particles are less likely to be sandwiched between the arcuate convex surface of the first Roots rotor and the arcuate concave surface of the second Roots rotor. As a result, the Roots rotors can maintain their smooth rotation.

### BRIEF DESCRIPTION OF THE DRAWINGS

FIG. 1 is a cross-sectional view showing an embodiment of a vacuum pump apparatus;
FIG. 2 is a cross-sectional view taken along a line A-A of FIG. 1;
FIG. 3 is an enlarged view of a Roots rotor;
FIG. 4 is an enlarged view illustrating a clearance between Roots rotors;
FIG. 5 is a diagram showing two Roots rotors when rotating in opposite directions;
FIG. 6 is a schematic diagram illustrating an embodiment of an arithmetic system for determining a shape of the Roots rotor;
FIG. 7 is a flowchart illustrating an embodiment of a method of determining the shape of the Roots rotor;
FIG. 8 is a graph showing a change in a clearance between a pair of Roots rotors when the Roots rotors make one rotation; and
FIG. 9 is a diagram showing an embodiment of three-lobe Roots rotors.

### DESCRIPTION OF EMBODIMENTS

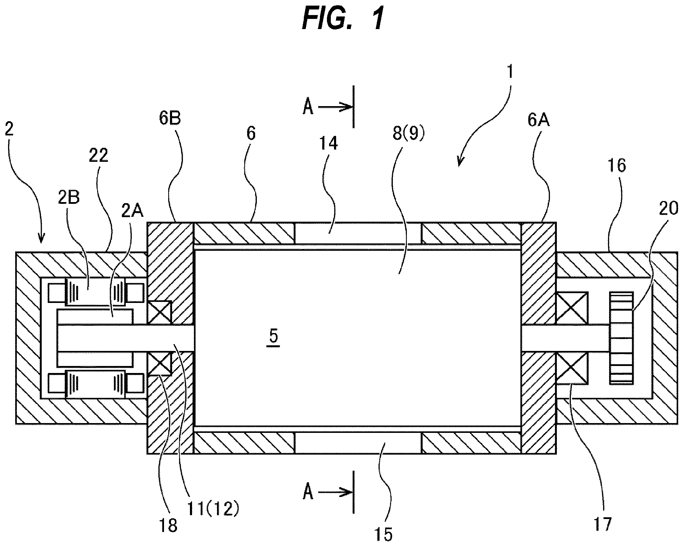

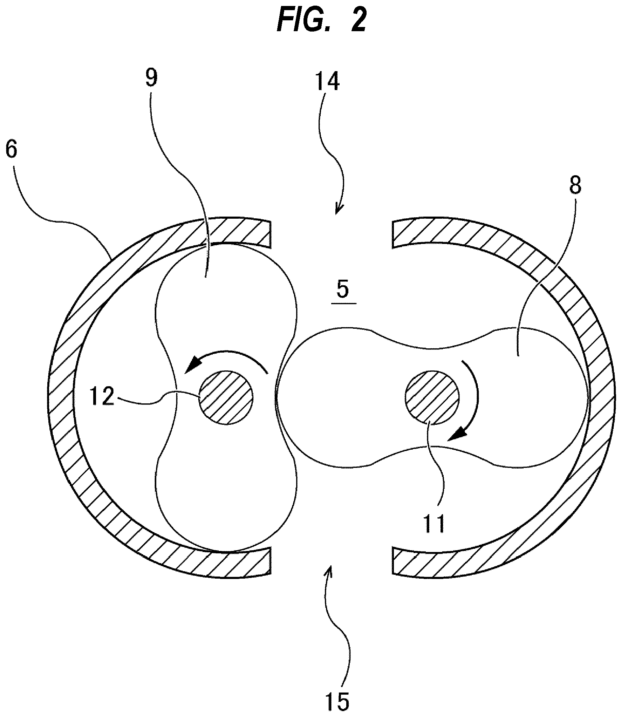

Embodiments of the present invention will be described below with reference to the drawings. FIG. 1 is a sectional view showing an embodiment of a vacuum pump apparatus, and FIG. 2 is a sectional view taken along line AA in FIG. 1. The vacuum pump apparatus of the embodiment described below is a positive displacement vacuum pump apparatus. In particular, the vacuum pump apparatus shown in FIGS. 1 and 2 is a so-called dry vacuum pump apparatus that does not use oil in its gas flow passage. Since vaporized oil does not flow to an upstream side, the dry vacuum pump apparatus can be used in semiconductor device manufacturing apparatus that requires high cleanliness.

As shown in FIG. 1, the vacuum pump apparatus includes a vacuum pump 1 and an electric motor 2 that drives the vacuum pump 1. The vacuum pump 1 of this embodiment is a single-stage vacuum pump. Specifically, the vacuum pump 1 includes a pump casing 6 having a rotor chamber 5 therein, single-stage Roots rotors 8 and 9 arranged in the rotor chamber 5, and a pair of rotational shafts 11 and 12 that support the Roots rotors 8 and 9, respectively. In one embodiment, the vacuum pump 1 may be a multi-stage vacuum pump having multi-stage Roots rotors arranged in a plurality of rotor chambers.

Although only the Roots rotor 8 and the rotational shaft 11 are depicted in FIG. 1, the Roots rotor 8 and the Roots rotor 9 are arranged in parallel in the pump casing 6, and the rotational shaft 11 and the rotational shaft 12 are arranged in parallel. FIG. 2 shows the Roots rotor 8 and the Roots rotor 9 arranged in parallel. The Roots rotor 8 is supported by the rotational shaft 11, and the Roots rotor 9 is supported by the rotational shaft 12.

The Roots rotor 8 and the Roots rotor 9 are not in contact with each other, and the Roots rotors 8 and 9 are not in contact with an inner surface of the pump casing 6. Therefore, the Roots rotors 8 and 9 can rotate smoothly in the pump casing 6 without using lubricating oil.

The Roots rotor 8 and the rotational shaft 11 may be an integral structure. Similarly, the Roots rotor 9 and the rotational shaft 12 may be an integral structure. The electric motor 2 is coupled to one of the rotational shafts 11 and 12. In one embodiment, a pair of electric motors 2 may be coupled to the rotational shafts 11 and 12, respectively.

The pump casing 6 has a gas inlet 14 and a gas outlet 15 that communicate with the rotor chamber 5. The gas inlet 14 is coupled to a chamber (not shown) filled with a gas to be delivered. In one example, the gas inlet 14 is coupled to a process chamber of a semiconductor-device manufacturing apparatus, and the vacuum pump 1 is used to evacuate a process gas that has been introduced into the process chamber.

The vacuum pump 1 further includes a gear housing 16 located outwardly of a side wall 6A of the pump casing 6. A pair of gears 20 that mesh with each other are arranged in the gear housing 16. In FIG. 1, only one gear 20 is depicted. These gears 20 are fixed to the rotational shafts 11 and 12, respectively. The electric motor 2 is rotated by a motor driver (not shown). One of the rotational shafts 11 and 12 to which the electric motor 2 is coupled is rotated by the electric motor 2. This rotation is transmitted via the gears 20 to other one of the rotational shafts 11 and 12 to which the electric motor 2 is not coupled to thereby rotate the other rotational shaft in the opposite direction.

The rotational shafts 11 and 12 are rotatably supported by bearings 17 held on the side wall 6A of the pump casing 6 and bearings 18 held on other side wall 6B of the pump casing 6. The electric motor 2 includes a motor housing 22 located outwardly of the side wall 6B of the pump casing 6, and a motor rotor 2A and a motor stator 2B arranged in the motor housing 22.

In one embodiment, a pair of electric motors 2 coupled to the rotational shafts 11 and 12, respectively, may be provided. The pair of electric motors 2 are synchronously rotated in opposite directions by a motor driver (not shown), so that the rotational shafts 11 and 12 and the Roots rotors 8 and 9 are synchronously rotated in the opposite directions, as shown in FIG. 2. The role of the gears 20 in this case is to prevent out of the synchronized rotation of the Roots rotors due to a sudden external cause.

When the electric motor 2 rotates the Roots rotors 8 and 9, gas is sucked into the rotor chamber 5 through the gas inlet 14. The gas is delivered to the gas outlet 15 by the rotation of the Roots rotors 8 and 9 in the rotor chamber 5, and is discharged from the pump casing 6 through the gas outlet 15.

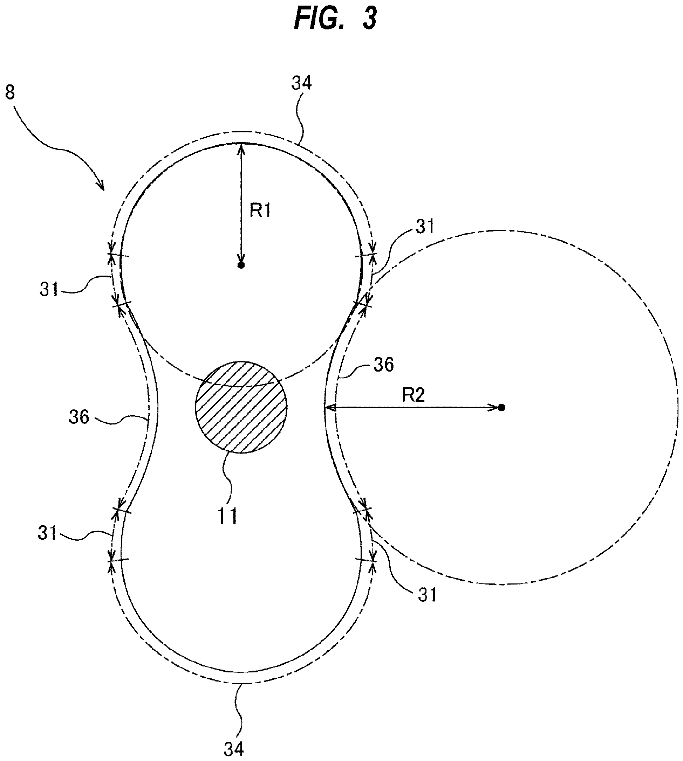

The Roots rotors 8 and 9 have the same contour. Therefore, the Roots rotor 8 will be explained below. FIG. 3 is an enlarged view of the Roots rotor 8. As shown in FIG. 3, the Roots rotor 8 includes an involute side surface 31 having a shape of an involute curve, an arcuate convex surface 34 coupled to an outer end of the involute side surface 31, and an arcuate concave surface 36 coupled to an inner end of the involute side surface 31. The Roots rotor 8 is a so-called two-lobe Roots rotor having two protrusions. Therefore, the Roots rotor 8 has two arcuate convex surfaces 34, four involute side surfaces 31, and two arcuate concave surfaces 36. The two arcuate convex surfaces 34 are coupled to the outer ends of the four involute side surfaces 31, and the two arcuate concave surfaces 36 are coupled to the inner ends of the four involute side surfaces 31. Each of the arcuate convex surface 34 and the arcuate concave surface 36 is longer than the involute side surface 31.

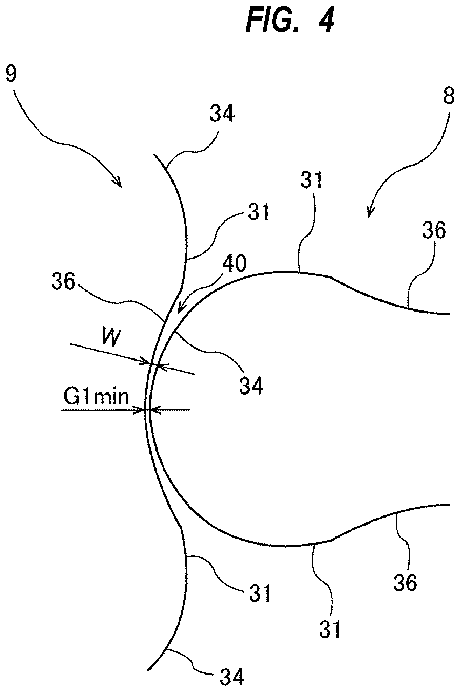

A radius of curvature R1 of the arcuate convex surface 34 is smaller than a radius of curvature R2 of the arcuate concave surface 36. In one embodiment, the radius of curvature R1 of the arcuate convex surface 34 is 0.2 to 0.9 times the radius of curvature R2 of the arcuate concave surface 36. Therefore, as shown in FIG. 4, when the arcuate convex surface 34 of the Roots rotor 8 faces the arcuate concave surface 36 of the Roots rotor 9, only one point on the arcuate convex surface 34 of the Roots rotor 8 and one point on the arcuate concave surface 36 of the Roots rotor 9 are close to each other, and as a result, a minimum clearance G1min is formed between the arcuate convex surface 34 and the arcuate concave surface 36. A width W of a space 40 formed between the arcuate convex surface 34 of the Roots rotor 8 and the arcuate concave surface 36 of the Roots rotor 9 gradually increases according to a distance from a position at which the minimum clearance Glmin is formed.

Since the radius of curvature R1 of the arcuate convex surface 34 of the Roots rotor 8 is smaller than the radius of curvature R2 of the arcuate concave surface 36 of the Roots rotor 9, the minimum clearance Glmin is formed between one point on the arcuate convex surface 34 of the Roots rotor 8 and one point on the arcuate concave surface 36 of the Roots rotor 9, and a clearance between the Roots rotors 8 and 9 gradually increases on both sides of the minimum clearance G1min. Therefore, the particles are less likely to be sandwiched between the arcuate convex surface 34 of the Roots rotor 8 and the arcuate concave surface 36 of the Roots rotor 9. As a result, the Roots rotors 8 and 9 can maintain smooth rotation.

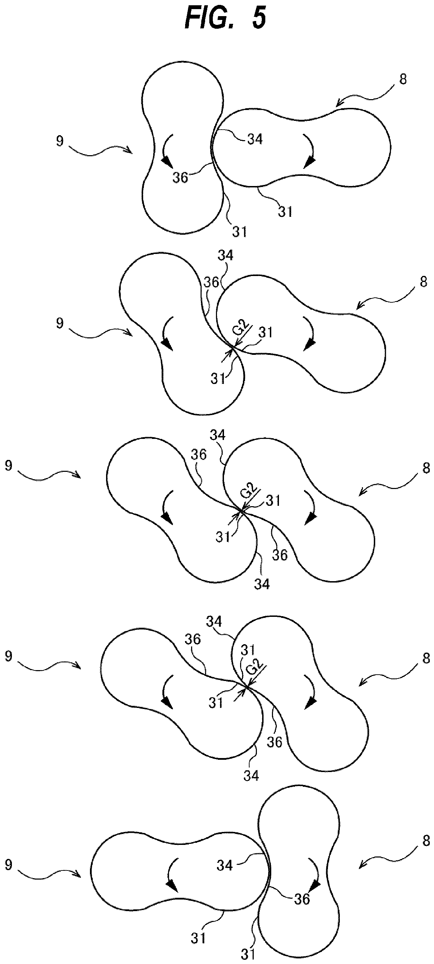

FIG. 5 is a diagram showing the two Roots rotors 8 and 9 when rotating in the opposite directions. As shown in FIG. 5, the involute side surfaces 31 of the Roots rotor 8 and the Roots rotor 9 face each other, and do not face the arcuate convex surface 34 and the arcuate concave surface 36. On the other hand, the arcuate convex surface 34 of the Roots rotor 8 faces the arcuate concave surface 36 of the Roots rotor 9 and does not face the involute side surface 31 of the Roots rotor 9. Similarly, the arcuate convex surface 34 of the Roots rotor 9 faces the arcuate concave surface 36 of the Roots rotor 8 and does not face the involute side surface 31 of the Roots rotor 8. When the Roots rotor 8 and the Roots rotor 9 are making one rotation, the Roots rotor 8 and the Roots rotor 9 are not in line contact but are in point contact (technically the Roots rotors 8 and 9 are in non-contact in reality). Therefore, particles are less likely to be caught between the Roots rotor 8 and the Roots rotor 9. A clearance G2 between the involute side surfaces 31 of the two Roots rotors 8 and 9 is constant at all times.

The involute side surface 31 is a surface that curves outward. Therefore, the clearance G2 is formed between one point on the involute side surface 31 of the Roots rotor 8 and one point on the involute side surface 31 of the Roots rotor 9, and a clearance between the Roots rotors 8 and 9 increases on both sides of the clearance G2. Due to such point contact (actually non-contact) of the involute side surfaces 31, particles are less likely to be caught between the involute side surface 31 of the Roots rotor 8 and the involute side surface 31 of the Roots rotor 9.

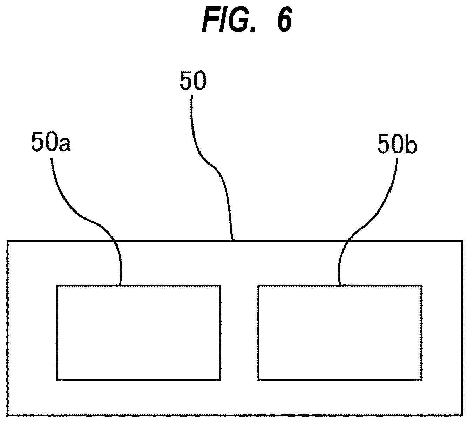

Next, a method of determining the shape of the Roots rotors 8 and 9 described above will be explained. Determination of the shape of the Roots rotors 8 and 9 is performed by an arithmetic system 50 shown in FIG. 6. This arithmetic system 50 includes a memory 50a that stores programs therein, and a processor 50b configured to execute arithmetic operations according to instructions included in the programs. The arithmetic system 50 is composed of at least one computer. The memory 50a includes a main memory, such as a random access memory (RAM), and an auxiliary memory, such as a hard disk drive (HDD) or a solid state drive (SSD). Examples of the processor 50b include a CPU (central processing unit) and a GPU (graphic processing unit). However, the specific configuration of the arithmetic system 50 is not limited to these examples.

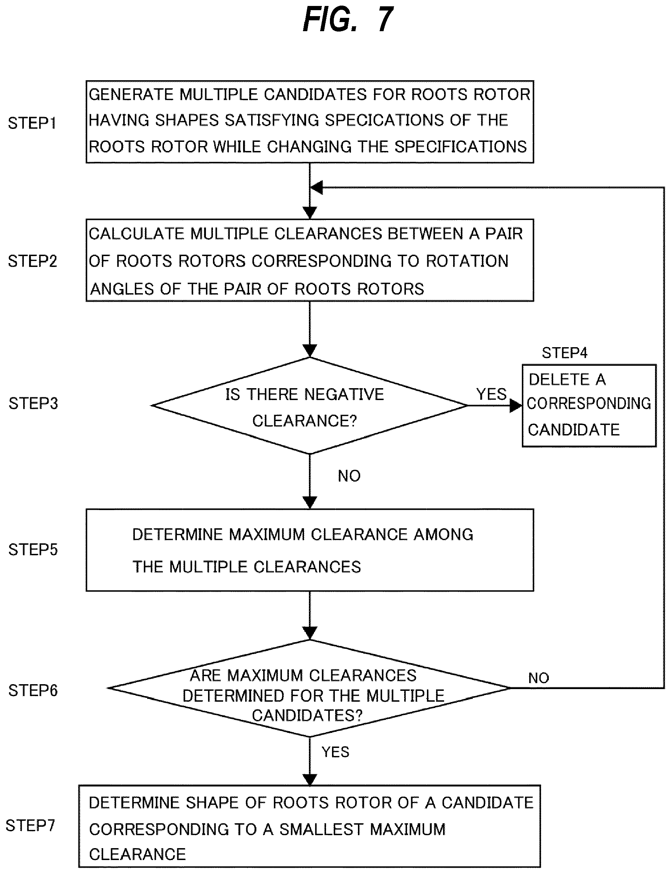

FIG. 7 is a flowchart illustrating an embodiment of the method of determining the shape of the Roots rotor.

In step 1, the arithmetic system 50 generates multiple candidates for a Roots rotor each having a shape that satisfies specifications of the Roots rotor while changing the specifications. The specifications of the Roots rotor include at least one of a distance between centers of a pair of Roots rotors, a pressure angle of involute side surface 31 of Roots rotor, a radius of Roots rotor, a clearance between Roots rotors, a radius of curvature of arcuate convex surface 34 of Roots rotor, and a radius of curvature of arcuate concave surface 36 of Roots rotor. The arithmetic system 50 generates multiple candidates for the Roots rotor each having a shape that satisfies the specifications while changing at least one of these factors (or conditions) that constitute the specifications. For example, the arithmetic system 50 generates multiple candidates for the Roots rotor each having a shape that satisfies the specifications while changing a pressure angle of the involute side surface 31 of the Roots rotor, a radius of curvature of the arcuate convex surface 34 of the Roots rotor, and a radius of curvature of the arcuate concave surface 36 of the Roots rotor.

In step 2, the arithmetic system 50 calculates multiple clearances between a pair of Roots rotors corresponding to rotation angles of the pair of Roots rotors having a shape of one of the multiple candidates. More specifically, the arithmetic system 50 calculates the multiple clearances between the pair of Roots rotors at predetermined intervals of rotation angle while rotating the Roots rotors having the shape of the candidate in the opposite directions in a virtual space.

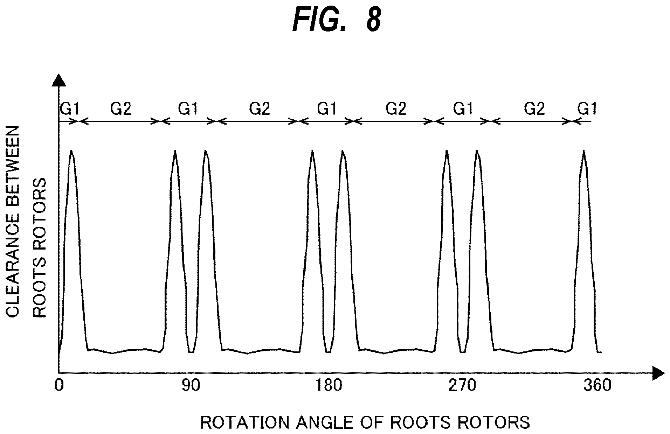

FIG. 8 is a graph showing a change in the clearance between the Roots rotors when the Roots rotors of a certain candidate make one rotation. In FIG. 8, a vertical axis represents the clearance between the Roots rotors, and a horizontal axis represents the rotation angle of the Roots rotors. When the involute side surfaces 31 of the two Roots rotors face each other, the clearance G2 between the Roots rotors is approximately constant. When the arcuate convex surface 34 and the arcuate concave surface 36 of the two Roots rotors face each other, the clearance G1 between the Roots rotors changes.

The arithmetic system 50 calculates the clearance between the Roots rotors at each rotation angle. Therefore, the multiple clearances corresponding to the multiple rotation angles are obtained. The arithmetic system 50 determines a maximum clearance among the multiple clearances obtained. In the example of FIG. 8, the maximum clearance is a peak value of the graph. If the maximum clearance is too large, the pumping performance of the vacuum pump 1 may be lowered.

Depending on the shape of the Roots rotors, the clearance between the Roots rotors calculated at a certain rotation angle may have a negative value. A negative clearance means that the Roots rotors are in contact. When the Roots rotors come into contact, the rotation of the Roots rotors is inhibited. Therefore, in step 3, the arithmetic system 50 determines whether there is a negative clearance among the multiple clearances that have been calculated in the step 2.

In step 4, if there is a negative clearance, the arithmetic system 50 deletes the candidate with the negative clearance from the multiple candidates generated in the step 1.

In step 5, the arithmetic system 50 determines a maximum clearance among the multiple clearances calculated for the candidates.

In step 6, the arithmetic system 50 repeats the calculation of the multiple clearances and the determination of the maximum clearance for the multiple candidates, and determines multiple maximum clearances corresponding to the multiple candidates. More specifically, the computing system 50 repeats the steps 2 to 5.

In step 7, the arithmetic system 50 determines a shape of the Roots rotor of a candidate corresponding to a smallest maximum clearance among the multiple maximum clearances determined in the step 6.

In this way, the shapes of the Roots rotors 8 and 9 described with reference to FIGS. 1 to 5 are determined.

In one embodiment, in the step 2, in order to calculate the multiple clearances between the Roots rotors at finer intervals of rotation angle, the arithmetic system 50 may calculate additional clearances by performing interpolation for the calculated multiple clearances along the rotation angle. Specifically, the arithmetic system 50 may interpolate additional clearances corresponding to additional rotation angles into the multiple clearances. An example of interpolation is spline interpolation. In the step 5, the maximum clearance is determined from among the multiple clearances calculated in the step 2 and the additional clearances.

The interpolation of clearances may be performed only in a predetermined rotation angle range. For example, the interpolation of clearances may be performed in a rotation angle range in which the arcuate convex surface 34 and the arcuate concave surface 36 face each other, as shown in FIG.4. In particular, the interpolation of clearances may be performed in a rotation angle range that includes the rotation angle at which the minimum clearance G1 is formed between the arcuate convex surface 34 and the arcuate concave surface 36 (i.e., a rotation angle of a bottom point between the two peak points in FIG. 8).

Although the Roots rotors 8 and 9 of the embodiments described above are two-lobe Roots rotors each having two protrusions, the present invention is not limited to the above embodiments. The present invention can be applied to three-lobe Roots rotor having three protrusions and multi-lobe Roots rotor having four or more protrusions.

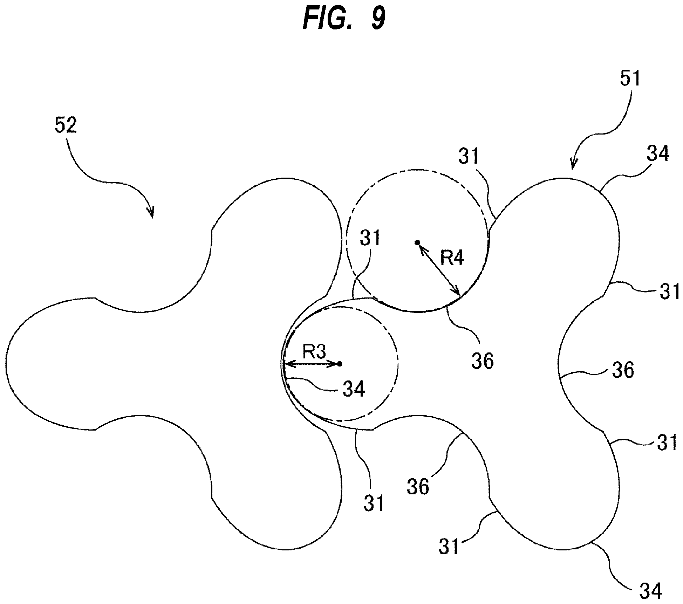

For example, FIG. 9 is a diagram illustrating an embodiment of three-lobe Roots rotors. In this embodiment also, each of Roots rotors 51 and 52 has an involute side surface 31 having a shape of an involute curve, an arcuate convex surface 34 coupled to an outer end of the involute side surface 31, and an arcuate concave surface 36 coupled to an inner end of the involute side surface 31. A radius of curvature R3 of the arcuate convex surface 34 is smaller than a radius of curvature R4 of the arcuate concave surface 36. Configurations of the three-lobe Roots rotors 51 and 52 of this embodiment, which will not be particularly described, are the same as those of the above embodiments described with reference to FIGS. 1 to 5, and redundant explanations will be omitted.

The embodiments of the method of determining the shape of the Roots rotor described with reference to FIGS. 6 to 8 can be applied to the three-lobe Roots rotor shown in FIG. 9 and to multi-lobe Roots rotor having four or more protrusions.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

## Claims

1. A vacuum pump comprising:
a pump casing having at least one rotor chamber therein; and
a first Roots rotor and a second Roots rotor arranged in parallel in the rotor chamber,
wherein each of the first Roots rotor and the second Roots rotor has an involute side surface having a shape of an involute curve, an arcuate convex surface coupled to an outer end of the involute side surface, and an arcuate concave surface coupled to an inner end of the involute side surface, and
a radius of curvature of the arcuate convex surface is smaller than a radius of curvature of the arcuate concave surface.

2. The vacuum pump according to claim 1, wherein each of the arcuate convex surface and the arcuate concave surface is longer than the involute side surface.

3. The vacuum pump according to claim 1, wherein a width of a space formed between the arcuate convex surface and the arcuate concave surface when facing each other increases with a distance from a position of a minimum clearance between the arcuate convex surface and the arcuate concave surface.

4. The vacuum pump according to claim 1, wherein the radius of curvature of the arcuate convex surface is 0.2 to 0.9 times the radius of curvature of the arcuate concave surface.

5. A method of determining a shape of a Roots rotor, comprising:
generating, by an arithmetic system, multiple candidates for the Roots rotor each having a shape that satisfies specifications of the Roots rotor while changing the specifications of the Roots rotor;
calculating, by the arithmetic system, multiple clearances between a pair of Roots rotors corresponding to multiple rotation angles of the pair of Roots rotors having a shape of one of the multiple candidates;
determining a maximum clearance among the multiple clearances;
repeating calculating of the multiple clearances and determining of the maximum clearance for the multiple candidates to determine multiple maximum clearances corresponding to the multiple candidates; and
determining a shape of the Roots rotor of a candidate corresponding to a smallest maximum clearance among the multiple maximum clearances.

6. The method according to claim 5, further comprising calculating additional clearances corresponding to additional rotation angles by performing interpolation for the multiple clearances corresponding to the multiple rotation angles,
wherein the maximum clearance is determined from among the multiple clearances and the additional clearances.

7. The method according to claim 5, wherein Roots rotors having the determined shape are the first Roots rotor and the second Roots rotor of any one of claims 1 to 3.

8. The method according to claim 7, wherein the specifications of the Roots rotor include at least one of a distance between centers of a pair of Roots rotors, a pressure angle of the involute side surface of Roots rotor, a radius of Roots rotor, a clearance between Roots rotors, a radius of curvature of the arcuate convex surface of Roots rotor, and a radius of curvature of the arcuate concave surface of Roots rotor.
